(19) **Europäisches Patentamt / European Patent Office / Office européen des brevets**

(11) **EP 1 918 345 B1**

(12) **EUROPEAN PATENT SPECIFICATION**

(45) Date of publication and mention
of the grant of the patent:
**20.04.2011 Bulletin 2011/16**

(51) Int Cl.:
***C09J 7/04*** (2006.01)

(21) Application number: **07021318.6**

(22) Date of filing: **31.10.2007**

(54) **Adhesive sheet for water jet laser dicing**

Klebefolie zum Schneiden mit Laserwasserstrahl

Feuille adhésive pour fragmentation laser à jet d'eau

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **06.11.2006 JP 2006299859**

(43) Date of publication of application:
**07.05.2008 Bulletin 2008/19**

(73) Proprietor: **NITTO DENKO CORPORATION Ibaraki-shi, Osaka 567-8680 (JP)**

(72) Inventors:
- **Asai, Fumiteru
  Ibaraki-shi
  Osaka 567-8680 (JP)**
- **Sasaki, Takatoshi
  Ibaraki-shi
  Osaka 567-8680 (JP)**
- **Miki, Tsubasa
  Ibaraki-shi
  Osaka 567-8680 (JP)**

- **Takahashi, Tomokazu
  Ibaraki-shi
  Osaka 567-8680 (JP)**
- **Shintani, Toshio
  Ibaraki-shi
  Osaka 567-8680 (JP)**
- **Yamamoto, Akiyoshi
  Ibaraki-shi
  Osaka 567-8680 (JP)**

(74) Representative: **Schmitz, Hans-Werner
  Hoefer & Partner
  Patentanwälte
  Pilgersheimer Strasse 20
  81543 München (DE)**

(56) References cited:
**EP-A- 0 478 784      EP-A- 0 926 732
EP-A- 1 139 415      US-A- 3 085 572
US-A1- 2006 124 241**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND OF THE INVENTION

1. Field of the Invention

The present invention relates to an adhesive sheet for water jet laser dicing, and more particularly relates to an adhesive sheet for water jet laser dicing used to fix a semiconductor wafer and/or a semiconductor-related material during dicing with a water jet laser.

2. Background Information

The conventional practice has been to use a rotary blade to cut semiconductor wafers, semiconductor-related materials and the like, and separate them into chips and IC parts. In this dicing step, the semiconductor wafer or the like is usually first affixed with an adhesive tape, for example, to fix it in place. After the semiconductor wafer or the like has been cut into chips, they are removed from the adhesive tape by a pick-up.

However, physical stress produced by the dicing blade can cause die fly-off in the chips and the like cut by this method, or cause cracking, chipping, and other such defects, which lowers the quality of the chips and the like, and also lowers the efficiency of this cutting method. In particular, this problem has become more serious as there has been greater demand for even smaller and thinner electronic devices in recent years.

In view of this, a dicing method that makes use of a laser beam, and particularly a method for processing materials by cutting, perforating, welding, stamping, peeling, or the like using a laser beam guided by a liquid jet, has been proposed as an alternative to techniques for cutting semiconductor wafers and the like with a dicing blade (see WO95/32834, for example). With this method, the wafer or the like is merely exposed to a water jet from above, which prevents die fly-off and the like caused by the physical stress produced by a rotating blade.

Also, with a cutting method that makes use of this laser technique, the use of a water jet can be a problem in that it makes the chips or the like more susceptible to coming loose from the adhesive tape that fixes them, and in an effort to deal with this, an adhesive tape has been proposed that can be used preferably in water jet laser dicing (see Japanese Laid-Open Patent Application 2001-316648, for example).

SUMMARY OF THE INVENTION

An object of the present invention is to provide an adhesive sheet that allows extremely thin semiconductor wafers or materials to be processed (i.e., workpiece), without causing chipping or other such defects during the separation of IC components, chips, or the like, by bringing about better and more stable permeability to liquids originating in a liquid stream during water jet laser dicing.

The present invention provides an adhesive sheet for water jet laser dicing, comprising an adhesive layer laminated on a base film, wherein the base film is composed of a woven mesh formed by a fiber, and wherein the base film has a fracture elongation of 100% or more.

According to the adhesive sheet for water jet laser dicing in the present invention, a film composed of mesh is used as the base film to ensure that the perforation size and opening area are relatively larger than in nonwoven fabric and perforated sheets, thus making it possible to maintain stable permeability to liquids originating in the liquid stream during water jet laser dicing and to provide an adhesive sheet that allows extremely thin semiconductor wafers or materials to be processed while preventing die fly-off or defects such as cracking and chipping in IC components, chips, or the like.

DETAILED DESCRIPTION OF THE PREFERRED EMBODIMENTS

The adhesive sheet for water jet laser dicing of the present invention mainly comprises a base film and an adhesive layer disposed on this base film. The phrase "adhesive sheet for water jet laser dicing" here refers to an adhesive sheet that is used in dicing with a laser beam guided by a liquid jet (usually a water jet), and with which the liquid used in this liquid jet during dicing, such as a liquid jet with at least a specific pressure, and the liquid that is applied directly or indirectly from the adhesive layer side can escape from one side of the adhesive sheet to the other side. The specific pressure here is usually about a few MPa or higher.

Examples of the base film include woven and the like (i.e., mesh) made of a fiber. Examples of the fiber include a polymer fiber of synthetic resin, for example, polyolefins such as polyethylene, polypropylene (e.g., low-density polyethylene, liner low-density polyethylene, high-density polyethylene, drawn polypropylene, non-drawn polypropylene, ethylene-polypropylene copolymer, ethylene-vinyl acetate copolymer, ethylene-(meth)acrylic acid copolymer, ethylene-(meth)acrylic ester copolymer and the like), polyester, polyethylene terephthalate, polyurethane, EVA, polytetrafluoroethylene, polyvinyl chloride, polyvinylidene chloride, polyamide, acetal resin, polystyrene, polysulfone, polycarbonate, nylon, fluorocarbon polymer, rubber-containing polymer such as styrene-butadiene copolymer, and the like; a synthetic fiber such as rayon, acetylcellulose and the like; a natural fiber such as cotton, silk, wool and the like; and a inorganic fiber such as glass fiber, carbon fiber and the like.

As used here, woven ordinarily means composition or texture, which can include a variety of compositions, in which warp yarn and weft yarn intersect perpendicularly or at a certain angle and are planarly joined in relatively close contact with adjacent yarns. The base film is preferably formed of a polyolefin or includes a layer composed of a polyolefin. This can ensure that both the strength and expandability are appropriate for laser dicing. This may be a single layer or a multilayered structure of two or more layers. The water resistance can be lowered to provide better water permeability for a single layer. The fibers may be either monofilaments or multifilaments. Water wettability and drainage will be better when formed using filaments. Monofilaments are preferred in order to make the mean perforation size of the mesh more uniform. The fiber diameter is preferably about 10 to 150 $\mu$m, and even more preferably about 25 to 80 $\mu$m from the standpoint of liquid permeability.

The opening diameter of the mesh of the base film is preferably about 5 to 800 $\mu$m, and more preferably about 5 to 500 $\mu$m in view of the small chip size of 1 mm or less of the material that is to be processed. The opening diameter means the diameter when the mesh is generally round, and means the length on one side when the mesh is a polygonal shape or the like. From another standpoint, the mesh size may suitable be, for example, about 10 $\mu$m$^2$ to 3.0 mm$^2$, preferably about 25 $\mu$m$^2$ or more, about 100 $\mu$m$^2$ or more, about 1000 $\mu$m$^2$ or more, about 0.1 mm$^2$ or more, and about 3.0 mm$^2$ or less, about 2.0 mm$^2$ or less, about 1.1 mm$^2$ or less.

If necessary, the base film, i. e., mesh film may be subjected to surface treatment such as corona discharge treatment, flame treatment, plasma treatment, sputter etching treatment, undercoating (e.g., primer), fluorine treatment; or degreasing treatment using a chemical solution on the surface thereof on which the adhesive film is formed for the enhancement of the adhesiveness to the adhesive film. Applying a primer is especially preferable. The thickness of the base film made of the mesh film is generally 10 to 400 $\mu$m, preferably 30 to 250 $\mu$m, for avoiding fracture or breaking of the sheet during processing the semiconductor wafer or the like as well as decreasing manufacturing cost.

The base film of the present invention has an elongation of 100% or more, over 100%, and more preferably over 150%. This is because stretching the base film makes it possible for the chips or the like to be easily picked up from the adhesive sheet after the dicing step.
Furthermore, the base film preferably has a tensile strength of over 0.1 N/20 mm, more preferably over 0.3 N/20 mm. The reason for this is to avoid breaking and/or cutting the adhesive sheet itself.

The elongation and tensile strength can be measured, for example, with a tensile tester using a sample with a length of 5.0 cm and a width of 20 mm. The tensile speed during the test is 300 mm/minute at room temperature (according to ASTM D1000). The elongation can be calculated as follows.

$$\text{Elongation (\%)} = (\text{Fracture Length} - \text{Original Length}) \div (\text{Original Length}) \times 100$$

The tensile strength is a value at fracturing.

The adhesive layer comprises an adhesive coated on one side of the base film. This adhesive may be any type of pressure sensitive, heat-sensitive, photosensitive, but it is suitably a type that is cured by an energy radiation, because this allows the layer to be easily removed from the workpiece. The energy radiation used here can be radiation of various wavelengths, such as ultraviolet rays, visible light rays, or infrared rays, but since the laser beam used for dicing is one with an oscillation wavelength less than 400 nm, such as a third or fourth harmonic of a YAG laser with an oscillation wavelength of 355 nm or 266 nm, XeCl excimer laser with an oscillation wavelength of 308 nm, or KrF excimer laser with an oscillation wavelength of 248 nm, or one with an oscillation wavelength greater than 400 nm, such as a titanium sapphire laser with a wavelength near 750 to 800 nm, which allows light absorption in the UV band via a multi-photon absorption process, which allows cutting at a width of 20 $\mu$m or less by multi-photon absorption ablation, and which has a pulse width of 1 e$^{-9}$ second or less, it is preferable to use an adhesive that will not be cured by a irradiation with the laser beam of the dicing apparatus being used.

A known adhesive including (meth)acrylic polymers and rubber-based polymers can be used as the material that forms the adhesive layer, but a (meth)acrylic polymer is particularly preferable because even when a photosensitive adhesive is formed, it can be cured without adding any special monomer/oligomer component or the like for an energy radiation curing.

Examples of rubber-based polymers include natural rubbers, such as polyisoprene; and synthetic rubbers, such as styrene-butadiene rubber or a rubber based on polybutadiene, butadiene-acrylonitrile, chloroprene and the like.

Examples of a monomer component of (meth)acrylic polymers include alkyl acrylates and alkyl methacrylates having linear or branched alkyl groups with 30 or fewer carbons, and preferably 4 to 18 carbons, such as methyl, ethyl, n-propyl, isopropyl, n-butyl, t-butyl, isobutyl, pentyl, isopentyl, hexyl, cyclohexyl, heptyl, 2-ethylhexyl, octyl, isooctyl, nonyl, isononyl, decyl, isodecyl, undecyl, rauryl, tridecyl, tetradecyl, stearyl, octadecyl, and dodecyl. These alkyl (meth) acrylates can be used alone or as mixture of more than two components.

Examples of a monomer component other than the above monomers include carboxyl-containing monomer such as acrylic acid, methacrylic acid, carboxyethyl (meth)acrylate, carboxypentyl (meth)acrylate; itaconic acid, maleic acid, fumaric acid, and crotonic acid; acid anhydride monomer such as maleic anhydride, itaconic anhydride; hydroxyl group-containing monomer such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydodecyl (meth)acrylate, 12-hydroxyrauryl (meth)acrylate, 4-hydroxymethyl cyclohexyl methyl(meth)acrylate; sulfonate-containing monomer such as styrenesulfonate, allylsulfonate, 2-(meth) acrylamide-2-methyl propanesulfonate, (meth)acrylamide propanesulfonate, sulfopropyl (meth)acrylate, (meth)acryloyl oxynaphthalenesulfonate; phosphate-containing monomer such as 2-hydroxyethyl acryloylphosphate; (meth)acrylamide; N-hydroxymethylamide (meth)acrylate; alkylamino alkylester(meth) acrylate such as dimethylamino ethylmethacrylate, t-butylamino ethylmethacrylate; N-vinylpyrrolidone; acryloyl morpholine; vinyl acetate; styrene; acrylonitrile and the like. These monomer components can be used alone or as mixture of more than two components.

Multifunctional monomers may be added as needed for the purpose of crosslinking (meth)acrylic polymer. Examples of the multifunctional monomer include 1,6-hexanediol di(meth)acrylate, polyethylene glycol di(meth)acrylate, polypropylene glycol di(meth)acrylate, neopentylglycol di(meth)acrylate, pentaerythritol di(meth)acrylate, trimethylolpropane tri(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, epoxy(meth)acrylate, polyester (meth)acrylate, urethane (meth)acrylate and the like. These multifunctional monomer components can be used alone or as mixture of more than two components. From the standpoint of adhesion characteristic and the like, the amount in which the multifunctional monomers are contained is preferably no more than 30 wt%, more preferably no more than 20 wt% of the total monomer component.

It is even more preferable to use a monomer and/or oligomer having an energy radiation curable functional group, such as a carbon-carbon double bond.

Examples of the monomer and/or oligomer include urethane (meth)acrylate, trimethylolpropane tri(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butylene glycol di(meth)acrylate and the like. These components can be used alone or as mixture of more than two components. There are no particular restrictions on the amount in which these are contained, but from the standpoint of adhesion characteristic, about 5 to 500 weight parts, or about 70 to 150 weight parts per 100 weight parts of the (meth)acrylic polymer or other base polymer of the adhesive is preferable.

It is preferable to use a photopolymerization initiator when a photosensitive adhesive is formed. Examples of the photopolymerization initiator include acetophenone compounds such as 4-(2-hydroxyethoxy) phenyl(2-hydroxy-2-propyl) ketone, α-hydroxy-α,α-methyl acetophenone, methoxy acetophenone, 2,2-dimethoxy-2-phenyl acetophenone, 2,2-diethoxy-acetophenone, 1-hydroxycyclohexyl phenyl ketone, 2-methyl-1-[4-(methyltio)phenyl]-2-morpholinoprophane-1; benzoine ether compounds such as benzoine ethyl ether, benzoine isopropyl ether, anisoin methyl ether; α-ketol compounds such as 2-methyl-2-hydroxypropylphenon; ketal compounds such as benzyldimethyl keral; aromatic sulfonyl chloride compounds such as 2-naphthalene sulfonyl chloride; light-active oxime compounds such as 1-phenon-1,1-propanedione-2-(o-ethoxycarbonyl) oxime; benzophenone compounds such as benzophenone, benzoylbenzoate, 3,3'-dimethyl-4-methoxybenzophenone; thioxanthone compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, 2,4-diisopropylthioxanthone; camphor quinone; ketone halide; acyl phosphinoxide; acyl phosphonate and the like. These components can be used alone or as mixture of more than two components. The amount in which the photopolymerization initiators are contained, about 0.1 to 10 weight parts, or about 0.5 to 5 weight parts per 100 weight parts of the base polymer of the adhesive is preferable.

A crosslinking agent may also be added to raise the weight average molecular weight of the base polymer. Examples of the crosslinking agent include polyisocyanate compounds, epoxy compounds, aziridine compounds, melamine resins, urea resins, anhydrous compounds, polyamines, carboxyl group-containing polymers and the like. These can be used alone or as mixture of more than two compounds. When a crosslinking agent is used, it is generally preferable for it to be used in an amount of about 0.01 to 5 weight parts per 100 weight parts base polymer so that the peeling-off adhesion strength will not decrease too much.

In addition to the above components, the adhesive may optionally comprise any conventional additive such as tackifiers, antioxidants, fillers, pigments and the like.

The acrylic polymer can be prepared, for example, by applying a known method such as solution polymerization, emulsion polymerization, mass polymerization, suspension polymerization to one or more kinds of monomer or a mixture thereof. Among these, solution polymerization is preferable. Examples of solvents that can be used include ethyl acetate, toluene and other such polar solvents. The solution concentration is usually about 20 to 80 wt%.

A polymerization initiator may be used in the preparation of the polymer. Examples of the polymerization initiator include peroxides such as hydrogen peroxide, benzoyl peroxide, t-butyl peroxide, and the like. One may be used by itself, or it may be combined with a reducing agent and used as a redox type of polymerization initiator. Examples of the reducing agent include ionic salts such as salts of iron, copper, cobalt, sulfite, bisulfite; amines such as triethanol amine; reducing sugar such as aldose, ketose and the like. Also, azo compounds such as 2,2'-azobis-2-methylpropioamidine salt, 2,2'-azobis-2,4-dimethylvaleronitrile, 2,2'-azobis-N,N'-dimethyleneisobutylamidine salt, 2,2'-azobisisobutyronitrile, 2,2'-azobis-2-methyl-N-(2-hydroxyethyl) propionamide may be used. These can be used alone or as mixture of more than two components.

The reaction temperature is usually about 50 to 85°C, and the reaction time about 1 to 8 hours. From the standpoint of preventing fouling of the workpiece and the like, it is preferable for the acrylic polymer to have a low content of low-molecular weight substances, and for the acrylic polymer to have a number average molecular weight of at least 300,000, particularly at a rage of about 800,000 to 3,000,000.

The thickness of the adhesive layer can be suitably adjusted within a range in which the layer will not come off the workpiece, but from the standpoints of ensuring adequate adhesive strength, preventing undesirable adhesive residue from remaining on the back of the semiconductor wafer or the like after the wafer or the like has been removed from the tape, and allowing water to pass through easily by cutting the adhesive layer, the thickness is usually about 1 to 50 $\mu$m, preferably about 3 to 20 $\mu$m. This minimizes resonance of the adhesive layer caused by vibration attributable to the liquid jet or irradiation with the laser beam during dicing, allows the oscillation amplitude to be suppressed, and prevents cracking, chipping, and the like of the chips. It also allows the workpiece to be securely fixed during dicing.

As discussed below, the adhesive layer may include at least one perforation, preferably two or more perforations as the base film does. This (these) perforation(s) can be formed by any of the methods discussed below for the base film. It is preferable, though, to form these perforations simultaneously with the perforations in the base film because they will then go all the way through from the base film to the adhesive layer, that is, the perforations in the base film overlap with the perforations in the adhesive layer.

The adhesive sheet of the present invention can be formed by a tape manufacturing method known in this field of technology. For example, the base film is provided first. The adhesive, then, can be laminated onto the base film. The base film may be coated directly, or a transfer coating process may be employed in which a process material coated with a release agent is coated with the adhesive and dried, after which the adhesive is laminated to the base film, or the adhesive may be laminated in a rolling mill on the base film. These coating process can be performed by any existing coating method, for example, reverse roll coating, gravure coating, curtain spray coating, die coating, extrusion and other industrially applied coating methods may be used. The base film that is prepared may have perforations already in the base film, or the perforations may be formed after the base film has been coated with the adhesive.

The adhesive sheet of the present invention has an adhesive strength of at least 1.5 N/20 mm, preferably at least 3 N/20 mm, and less than 10 N/20 mm, preferably less than 8 N/20 mm. In other words, along with changes in dicing technology to technology involving the use of a water jet laser, the critical significance of the adhesive strength of an adhesive sheet used for dicing is also changing, and as a result, good adhesion with the wafer or the like during dicing can be ensure even at a weaker adhesive strength, and chips or parts can be prevented from coming loose from the adhesive tape. In addition, a reduction in the initial adhesive strength allows chipping and other such defects to chips, IC parts, and the like during pick-up to reduce. In particular, in the case of a photosensitive adhesive, the adhesive strength of the adhesive after irradiation can be effectively, quickly, and easily reduced. The adhesive strength after irradiation is preferably less than 0.2 N/20 mm, more preferably less than 0.18 N/20 mm.

Here, an adhesive strength is the value which is measured on an Si-mirror wafer under the conditions of 23 $\pm$ 3 °C, 180 ° peeling angle and a peeling speed of 300 mm/min (according to ASTM D1000).

Examples of the adhesive sheet for water jet laser dicing of the present invention will now be described in detail.

(Preparation of Adhesive)

60 weight parts methyl acrylate, 35 weight parts 2-ethylhexyl acrylate, and 5 weight parts of acrylic acid were copolymerized by a standard method in ethyl acetate to obtain a solution containing an acrylic copolymer with a weight average molecular weight of 700,000.

To this solution were added 100 weight parts UV-curing oligomer (viscosity of 10 Pa · sec at 25 °C) that was obtained by reaction of pentaerythritol triacrylate and diisocyanate, 3 weight parts photopolymerization initiator (trade name "Irgacure 651," made by Ciba Specialty Chemicals), and 2 weight parts polyisocyanate compound (trade name "Coronate L," made by Nippon Polyurethane Industry), which gave a UV-curing acrylic adhesive solution.

Example

Adhesive sheets for laser dicing were prepared by applying adhesive, produced in the manner described above, to a thickness of 10 $\mu$m on base films made by mesh films having a mean thickness of 45 $\mu$m, respectively. The base films ware composed of 20 $\mu$m fabric diameter polyethylene terephthalate having a mean opening diameter of 30 $\mu$m (opening area 30%), 50 $\mu$m (opening area 55%), and 100 $\mu$m (opening area 85%), respectively.

Comparative Example 1

A adhesive sheet for laser dicing was prepared by applying adhesive, produced in the manner described above, to a thickness of 10 $\mu$m on base film which is unwoven fabric, made by polypropylene, and having the thickness of 80 $\mu$m and porosity of 60%.

Comparative Example 2

A adhesive sheet for laser dicing was prepared by applying adhesive, produced in the manner described above, to a thickness of 10 $\mu$m on base film which is unwoven fabric, made by polypropylene, and having the thickness of 80 $\mu$m and porosity of 80%.

(Evaluation)

Silicon wafers were diced using the adhesive sheets produced in the example and comparative examples, and the chip fly number and chipping rate during processing were compared.
Die fly rate (chip fly rate, %) is calculated at dicing semiconductor chips in the following conditions.
Laser wavelength: 1064 nm,
Dicing speed: 50 mm/s,
Laser diameter: 50 $\mu$m,
Water jet pressure: 40 MPa,
Chip size: 1 mm $\times$ 1 mm,
Wafer size: 13.7 cm (5 inch),
Wafer thickness: 150 $\mu$m.
Chip fly was calculated based on the number of chips scattered per square millimeter. Chipping was calculated based on the percentage of the number of chips in which chipping occurred to a depth of at least 25 $\mu$m, as viewed in the direction of the chip cross section.

Table 1

| | | Base Film | Opening Diameter/ Porosity | Die fly Rate | Chipping Rate |
|---|---|---|---|---|---|
| Ex. | | Mesh | 30$\mu$m (30%)<br>50$\mu$m (50%)<br>100$\mu$m (85%) | 0% (0/about 14500)<br>0% (0/about 14500)<br>0% (0/about 14500) | 11.5% (23/200)<br>8.0% (16/200)<br>7.0% (14/200) |
| Comp. Ex.1 | | Nonwoven Fabric | 60% | 5.7% (862/about 14500) | 23% (46/200) |
| Comp. Ex. 2 | | Nonwoven Fabric | 80% | 2.3% (332/about 14500) | 19% (38/200) |

Table 1 shows that when the base film was composed of mesh, both the chip fly rate and percentage of chipping could be controlled better than in nonwoven fabric, regardless of porosity. It was found in particular that water originating in the stream of water was readily drained from the adhesive sheet, that sufficient adhesion between the adhesive and chips could be ensured, and that no chip fly occurred.
Regardless of porosity in Comparative Example 1, on the other hand, the water drainage was not stable, sufficient adhesion between the adhesive and chips could not be ensured, chip fly occurred, and chipping occurred as a result of decreases in adhesion.
The adhesive sheet for water jet laser dicing of the present invention can be utilized in a wide range of applications in which a material is diced with a laser beam guided by a liquid jet, that is, it can be applied not only to semiconductor-related materials and the like (such as semiconductor wafers, BGA packages, printed wiring boards, ceramic boards, glass member for liquid crystal devices, sheet materials, circuit boards, glass substrates, ceramics substrates, metal substrates, light-emitting and light-receiving element substrates for semiconductor laser, MEMES substrates, semiconductor packages), but to all kinds of materials.
This application claims priority to Japanese Patent Application No. 2006-299859.
While only selected embodiments have been chosen to illustrate the present invention, it will be apparent to those skilled in the art from this disclosure that various changes and modifications can be made herein without departing from the scope of the invention as defined in the appended claims. Furthermore, the foregoing descriptions of the embodiments according to the present invention are provided for illustration only, and not for the purpose of limiting the invention as defined by the appended claims. Thus, the scope of the invention is not limited to the disclosed embodiments.

**Claims**

1. An adhesive sheet for water jet laser dicing, comprising an adhesive layer laminated on a base film, wherein the base film is composed of a woven mesh formed by a fiber and wherein the base film has a fracture elongation of 100% or more, wherein the elongation is measured with a tensile tester using a sample with a length of 5.0 cm and a width of 20 mm, wherein the tensile speed during the test is 300 mm/minute at room temperature according to ASTM D100, and wherein the elongation is calculated as elongation = (fracture length - original length)/(original length) X 100%.

2. The adhesive sheet according to Claim 1, wherein the base film is formed as a woven by a fiber comprising a monofilament or multifilament.

3. The adhesive sheet according to Claim 1, wherein the base film has a porosity of 3 to 90%.

4. The adhesive sheet according to Claim 1, wherein the base film has the perforations being from 10 $\mu$m$^2$ to 3.0 mm$^2$ in size.

5. The adhesive sheet according to Claim 1, wherein the base film has a tensile strength of over 0.1 N/20 mm, wherein the tensile strength is measured with a tensile tester using a sample with a length of 5.0 cm and a width of 20 mm, wherein the tensile speed during the test is 300 mm/minute at room temperature according to ASTM D100 and wherein the tensile strength is a value at fracturing.

**Patentansprüche**

1. Klebefolie zum Wasserstrahl-Laserschneiden, umfassend eine Klebeschicht, die auf eine Basisfolie aufgebracht ist, wobei die Basisfolie aus einem gewobenen Gewebe aus einer Faser besteht und wobei die Basisfolie eine Bruchdehnung von 100 % oder mehr aufweist, wobei die Dehnung mit einem Zugprüfgerät unter Verwendung einer Probe mit einer Länge von 5,0 cm und einer Breite von 20 mm gemessen wird, wobei die Zuggeschwindigkeit während des Tests 300 mm/Minute bei Raumtemperatur gemäß ASTM D100 beträgt, und wobei die Dehnung als

$$\text{Dehnung} = (\text{Bruchlänge} - \text{ursprüngliche Länge}) / (\text{ursprüngliche Länge}) \times 100\%$$

berechnet ist.

2. Klebefolie nach Anspruch 1, wobei die Basisfolie als ein Gewebe durch eine Faser, die ein Monofilament oder ein Multifilament umfasst, ausgebildet ist.

3. Klebefolie nach Anspruch 1, wobei die Basisfolie eine Porosität von 3 bis 90 % aufweist.

4. Klebefolie nach Anspruch 1, wobei die Basisfolie Perforationen in einer Größenordnung von 10 $\mu$m$^2$ bis 3,0 mm$^2$ aufweist.

5. Klebefolie nach Anspruch 1, wobei die Basisfolie eine Zugfestigkeit von über 0,1 N/20 mm aufweist, wobei die Zugfestigkeit mit einem Zugprüfgerät unter Verwendung einer Probe mit einer Länge von 5,0 cm und einer Breite von 20 mm gemessen wird, wobei die Zuggeschwindigkeit während des Tests 300 mm/Minute bei Raumtemperatur gemäß ASTM D100 beträgt, und wobei die Zugfestigkeit ein Wert beim Brechen ist.

**Revendications**

1. Feuille adhésive pour fragmentation laser à jet d'eau, comprenant une feuille adhésive déposée en couche sur un film de base, dans laquelle le film de base est composé d'un maillage tissé à l'aide d'une fibre et dans laquelle le film de base possède un taux d'allongement à la rupture de 100% ou plus, dans laquelle l'allongement est mesuré à l'aide d'un testeur à la traction utilisant un échantillon avec une longueur de 5,0 cm et une largeur de 20 mm, dans laquelle la vitesse de traction lors du test est de 300 mm/min à température ambiante selon la norme ASTM D100, et dans laquelle l'allongement est calculé selon la formule : allongement - (longueur à la rupture - longueur initiale) /(longueur initiale)x100%.

2. Feuille adhésive selon la revendication 1, dans laquelle le film de base est formé d'un tissage à l'aide d'une fibre comprenant un monofilament ou un multifilament.

3. Feuille adhésive selon la revendication 1, dans laquelle le film de base possède une porosité de 3 à 90%.

4. Feuille adhésive selon la revendication 1, dans laquelle le film de base possède des perforations d'une taille comprise entre 10 $\mu m^2$ et 3,0 $mm^2$.

5. Feuille adhésive selon la revendication 1, dans laquelle le film de base possède une résistance à la traction supérieure à 0,1 N/20 mm, dans laquelle la résistance à la traction est mesurée à l'aide d'un testeur à la traction utilisant un échantillon ayant une longueur de 5,0 cm et une largeur de 20 mm, dans laquelle la vitesse de traction lors du test est de 300 mm/min à température ambiante selon la norme ASTM D100, et dans laquelle la résistance à la traction est une valeur à la rupture.

## REFERENCES CITED IN THE DESCRIPTION

### Patent documents cited in the description

- WO 9532834 A
- JP 2001316648 A
- JP 2006299859 A